(19) Europäisches Patentamt
European Patent Office
Office européen des brevets

(11) Numéro de publication: **0 126 014**
**B1**

(12) **FASCICULE DE BREVET EUROPÉEN**

(45) Date de publication du fascicule du brevet: **25.11.87**

(51) Int. Cl.⁴: **C 25 D 5/56**

(21) Numéro de dépôt: **84420060.0**

(22) Date de dépôt: **03.04.84**

(54) **Procédé de métallisation de films souples électriquement isolants en matière plastique thermostable et articles obtenus.**

(30) Priorité: **15.04.83 FR 8306404**

(43) Date de publication de la demande:
**21.11.84 Bulletin 84/47**

(45) Mention de la délivrance du brevet:
**25.11.87 Bulletin 87/48**

(84) Etats contractants désignés:
**AT BE CH DE FR GB IT LI LU NL SE**

(56) Documents cité:
**EP-A-0 082 094**
**DE-A-2 623 695**
**FR-A-2 518 126**

**Encyclopedy of Chemical Technology, Kirk Othmer, 3ième. édition, vol. 10, page 216**

(73) Titulaire: **RHONE- POULENC RECHERCHES, 25 Quai Paul Doumer, F-92408 Courbevoie Cedex (FR)**

(72) Inventeur: **Cassat, Robert, Chemin de Crapon, F-69360 Ternay (FR)**

(74) Mandataire: **Varnière- Grange, Monique, RHONE- POULENC INTERSERVICES Service Brevets Chimie Centre de Recherches de Saint- Fons B.P. 62, F-69192 Saint- Fons Cédex (FR)**

EP 0 126 014 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1987

**Description**

Le développement incomparable de l'électronique dans tous les domaines de la vie courante comme dans les domaines industriels de pointe est la cause de très nombreuses recherches pour miniaturiser ou pour rendre sans cesse moins onéreux les différents constituants nécessaires.

La présente invention a pour objet un procédé de métallisation de films électriquement isolants en matière plastique thermostable. Elle concerne également les produits intermédiaires et les produits finis qui ont été fabriqués par ce procédé. La présente invention a trait plus particulièrement à un procédé permettant d'appliquer des dépôts métalliques très adhérents et ductiles sur des films souples en faisant appel de préférence à des moyens électrolytiques mais aussi éventuellement à des moyens chimiques.

Les films souples sont abondamment utilisés aussi bien comme support de circuiterie (circuits imprimés) que comme constituant de systèmes électroniques. Il est alors nécessaire de pouvoir obtenir aussi bien en surface que dans l'épaisseur des zones bien délimitées ayant soit des propriétés conductrices soit des propriétés isolantes électriquement.

Après avoir utilisé pendant longtemps des substrats rigides de type papier enduit de bakélite puis de résines phénoliques ou de résines époxy, on s'oriente maintenant vers des substrats souples en polymères thermoplastiques ou thermodurcissables filmogènes. On choisira ces polymères selon les usages et les impératifs retenus:

Polytéréphtalate d'éthylèneglycol, polypropylène, polyacétal si l'on ne cherche pas de haute tenue en température, polymères fluorés, polyéthersulfone, polyétherimide, polyphénylènesulfure, polyphénylène oxyde modifié, polyarylate, polybenzimidazole, polyimides amides, polyimides ou polyamides aromatiques si l'on cherche une bonne tenue en température.

De très nombreux procédés ont été décrits dars la littérature pour métalliser un film de matière plastique en surface. Nous passerons rapidement sur les procédés qui mettent en oeuvre le contrecollage par divers moyens, de pellicules métalliques sur le film plastique, et sur les procédés mettant en oeuvre des dépôts conducteurs ou isolants, constitués d'un liant qui adhère au support et d'un composé minéral isolant ou conducteur électrique.

Nous signalerons toutefois le procédé P 25 de Philips décrit dans "Electronic Production" Décembre 1973 page 8 qui est bien représentatif de l'art antérieur. Il fait appel à un procédé de réduction du palladium.

L'originalité réside dans la sensibilisation de $TiO_2$ dispersé dans la masse du film par la lumière (rayonnement de 365 nm) et la réduction du chlorure de palladium en palladium métallique. En un second temps il est nécessaire de renforcer par un procédé chimique, la couche métallique de surface. Ce procédé présente donc l'inconvénient de ne pouvoir agir qu'en surface et d'autre part nécessite l'emploi de procédé chimique de métallisation.

Parmi les autres procédés on retiendra celui décrit dans le brevet USP 3 767 538 qui consiste à rendre rugueuse la surface de film polyester ou polyimide par traitement chimique, à y créer des germes conducteurs en palladium, à y déposer par méthode chimique ou évaporation une couche d'argent qui sera ultérieurement renforcée par procédé chimique. On remarquera que ce procédé est long et coûteux.

La demande antérieure EP-A-0 082 094 publiée le 22 juin 1983, désignant les états contractants BE, DE, GB, IT, NL et SE et étant pour ces états comprises dans l'état de la technique, conformément à l'article 54 (3) et (4) de la CBE, décrit un procédé d'obtention de plaquettes épaisses de 2 mm, électriquement isolantes par pressage à chaud d'un mélange à sec, pastillé, d'un prépolymère polyimide et de particules d'oxyde cuivreux, suivi d'un décapage superficiel et d'une réduction de l'oxyde cuivreux en cuivre métallique avec une solution aqueuse de borohydrure de sodium pour obtenir une surface conductrice d'électricité sur laquelle on procédé alors à un cuivrage électrolytique.

La nécessité se faisait sentir de mettre au point une technique pour la réalisation de films supports pour l'industrie électronique visant à réaliser les objectifs suivants:

- réduction importante des coûts de production (tracé, perçage, ébavurage),
- amélioration de la qualité des circuits finis,
- augmentation de la densité d'interconnexion,
- respect des normes de plus en plus sévères de pollution.

Il était nécessaire que le nouveau procédé soit adapté à la réalisation de la circuiterie plane rigide ou souple et des trous métallisés. Il fallait aussi que le dépôt métallique soit de bonne qualité: adhérence au support - cohérence du dépôt et rapport des dépôts dans les trous par rapport au dépôt plan, supérieur ou égal à 1.

Il a été maintenant trouvé et c'est ce qui constitue l'un des objets de la présente invention un procédé permettant de rendre conductrices des zones bien déterminées, qui peuvent être renforcées directement si nécessaire par un procédé électrolytique. On a ainsi surmonté l'obstacle de l'emploi de la métallisation chimique (ou dépôt chimique sans courant) qui est une méthode lente dont la vitesse de dépôt est de l'ordre de un micron par heure, et perd donc tout son intérêt quand il s'agit d'obtenir des couches métalliques dont l'épaisseur va dépasser vingt microns environ. Pour obtenir de pareilles couches épaisses, on procéde en général d'abord à un dépôt chimique sans courant de l'ordre de quelques microns par exemple, puis on effectue ensuite un second dépôt par voie électrolytique. La voie électrolytique est incomparablement plus

rapide, puisque sa vitesse de dépôt est de l'ordre de cinquante à cent microns par heure.

Un autre objet de l'invention est la réalisation de films souples polymèriques qui peuvent être revêtus d'une couche de cuivre ayant une épaisseur de l'ordre du micron. Cette couche, dont la résistivité superficielle est comprise entre 0,01 Ω/□ et $10^3$ Ω/□, suffit à rendre conducteur de l'électricité le film. De plus étant ancrée dans le film lui-même, elle est de ce fait très cohérente avec lui. On peut déposer ultérieurement des couches métalliques plus épaisses dont l'adhérence est excellente. On peut aussi par l'emploi de surcouches minces en métal fondant à basse température rendre soudable de tels films.

Il a été trouvé un procédé de métallisation de films souples électriquement isolants en polymère thermodurcissable à groupements imides ou amides aromatiques, caractérisé en ce qu'il comprend la succession d'étapes suivantes:

(1) on prépare un collodion filmogène du polymère thermodurcissable ou d'un prépolymère de celui-ci, contenant de 20 à 60 % en poids d'un oxyde cuivreux sous forme de particules,

(2) on forme un film à partir du collodion obtenu,

(3) on met à jour, si besoin est, sur au moins une portion de la surface du film, les grains d'oxyde cuivreux,

(4) on réduit l'oxyde cuivreux en cuivre métallique par traitement avec un borohydrure d'au moins une portion de la surface du film pour la rendre conductrice de l'électricité,

(5) on renforce ladite surface, éventuellement par voie électrolytique.

Par l'emploi de tels films on peut réaliser des circuits imprimés par les étapes suivantes:

a) enduction par un photoresist du film réduit éventuellement renforcé électrolytiquement,

b) développement du photorésist,

c) renforcement électrolytique direct,

d) élimination du photorésist,

e) gravure non sélective.

Par polymère à groupements imides ou amides aromatiques on entend essentiellement des polymères thermodurcissables ayant de bonnes propriétés de thermostabilité. De tels polymères sont décrits, entre autres, dans les brevets français No. 1 256 203, 1 239 491, 1 472 898 ou No. 2 134 581 et correspondent à des produits commercialisés par la Société Du Pont de Nemours sous les marques de KAPTON$^R$, KEVLAR$^R$ ou VESPEL$^R$ ou dans les brevets français No. 1 555 564, 1 575 839, 2 046 498, 2 094 607, 2 260 596, 2 422 696 ou les brevets américains No. 3 562 229 et 3 658 764 et correspondent à des produits commercialisés par la Société RHONE-POLENC sous la marque de KINEL$^R$ ou KERIMID$^R$ ou dans la demande de brevet japonais No. J 52 085 474 correspondant au polyimidiso - indolquinazolinedione (PIQ) commercialisé par la Société HITACHI ou dans les brevets américains No. 3.787.364, 3.833.681, 3.838.097, 3.875.116, 3.968.083, 3.983.093, 3.991.004, ou les demandes de brevets allemands No. 2.261.714, 2.261.715, 2.363.785, 2.364.246, ou la demande de brevet néerlandais No. 74/08.336 et correspondent à des polyétherimides commercialisés par la Société GENERAL ELECTRIC.

On utilise une quantité d'oxyde cuivreux comprise entre 20 et 60 % en poids du sec de la composition totale et de préférence entre 30 et 50 %. Cet oxyde doit se présenter sous la forme de particules de très petites dimensions. La granulométrie est en générale comprise entre 0,1 et 5 microns.

On peut ajouter à la composition des additifs du type de ceux utilisés pour les peintures dans le but d'améliorer la mise en suspension de l'oxide et de stabiliser cette suspension. Des agents mouillants, des colloïdes protecteurs, des émulsifiants, des agents glissants peuvent aussi être utilisés à condition qu'ils ne modifient pas la résistivité des collodions et des films obtenus.

Dans le cas où le prépolymère est un imide-amide on pourra ajouter de l'anhydride trimellique qui favorisera le décollage ultérieur du film de son support de coulée.

Lors de la préparation du collodion, on dissout en un premier temps le prépolymère dans un solvant approprié jusqu'à obtenir une solution, ou bien on réalise la prépolymérisation en milieu solvant. On ajoute ensuite l'oxyde cuivreux.

La solution de prépolymère chargée d'oxyde cuivreux est ensuite traitée par des moyens analogues à ceux utilisés pour la préparation des peintures: turbines du type Rayneri à grande vitesse de rotation, passages successifs sur des appareils de type tricylindre ou monocylindre sur barre par exemple.

Le but de ce traitement est de diviser au maximum les agglomérats d'oxyde cuivreux et de les disperser en grain unitaire.

Le film est ensuite conformé principalement par coulée puis séché et polymérisé selon les techniques habituelles d'obtention de ce type de films.

Le plus souvent on est amené en pratique à réaliser ensuite un étirage du film ou un biétirage pour donner des caractéristiques mécaniques au film. On a constaté que ce traitement suffisait pour mettre à jour les grains d'oxyde métallique et les débarrasser de la pellicule qui pouvait les recouvrir, sans avoir recours à un traitement superficiel de décapage (sablage, rouleaux abrasifs, tranchage.... ou traitement chimique).

Dans certains cas, toutefois, on désire mettre en oeuvre un film non étiré et il peut alors s'avérer nécessaire de mettre à jour les grains d'oxyde par un traitement superficiel de décapage comme indiqué ci-avant.

Le film pourra alors, suivant les besoins, subir un traitement de stabilisation thermique et/ou être perforé selon un schéma préétabli si le film est destiné à la fabrication de circuits à trous traversants.

La résistivité superficielle du film que l'on veut obtenir avant renforcement par électrolyse

dépend du taux d'oxyde cuivreux mais aussi de l'importance de la réduction opérée. On a trouvé que la surface du film avant renforcement électrolytique présente avantageusement une résistivité superficielle comprise entre 0,01Ω/□ et environ $10^3$Ω/□.

On a constaté que la transformation de l'oxyde cuivreux en cuivre métallique peut être conduite facilement et de manière quantitative par action des borohydrures. La transformation est représentée par la réaction:

$$_4Cu_2O + BH^-_4 \rightarrow {}_8Cu + B(OH)_3 + OH^-$$

Cette facilité de réaction est probablement due à l'effet catalytique du cuivre métal qui pourrait s'expliquer par la formation intermédiaire d'hydrure de cuivre instable.

Les borohydrures utilisables dans la présente invention englobent des borohydrures substitués aussi bien que des borohydrures non substitués. Des borohydrures substitués dans lesquels au plus trois atomes d'hydrogène de l'ion borohydrure ont été remplacés par des substituants inertes dans les conditions de réduction, comme par exemple des radicaux alkyles, des radicaux aryles, des radicaux alkoxy peuvent être utilisés. On fait appel de préférence à des borohydrures alcalins dans lesquels la partie alcaline consiste en du sodium ou du potassium. Des exemples typiques de composés qui conviennent sont: le borohydrure de sodium, le borohydrure de potassium, le diéthylborohydrure de sodium, le triméthoxyborohydrure de sodium, le triphénylborohydrure de potassium.

Le traitement réducteur est conduit de manière simple par mise en contact du film avec une solution de borohydrure dans l'eau ou dans un mélange d'eau et d'un solvant polaire inerte ccmme par exemple un alcool aliphatique inférieur. On donne la préférence aux solutions purement aqueuses de borohydrure. La concentration de ces solutions peut varier dans de larges limites et elle se situe de préférence entre 0,05 et 1 % en poids d'hydrogène actif du borohydrure par rapport à la solution. Le traitement réducteur peut être effectué à température élevée, cependant on préfère le mettre en oeuvre à une température voisine de la température ambiante, par exemple entre 15° C et 30° C. A propos du déroulement de la réaction, il faut noter qu'elle donne naissance à du $B(OH)_3$ et à des ions $OH^-$ qui ont pour effet d'induire une augmentation du pH du milieu au cours de la réduction. Or à des valeurs de pH élevées, par exemple supérieures à 13, la réduction est ralentie de sorte qu'il peut être avantageux d'opérer dans un milieu tamponné pour avoir une vitesse de réduction bien déterminée. Après réduction on rince le film.

En début de réduction, la réaction concerne essentiellement les grains d'oxyde cuivreux qui se trouvent en surface du substrat et qui sont en contact direct avec l'agent réducteur. Du fait de l'effet catalytique du cuivre métal, la réaction de réduction va se poursuivre ensuite dans l'épaisseur du film et ceci bien que les résines utilisées ne présentent pas un caractère hydrophile particulièrement marqué. C'est donc en jouant principalement sur la durée du traitement qu'il est possible de contrôler aisément l'importance de la réduction opérée. Pour obtenir une résistivité répondant aux valeurs souhaitées, la durée du traitement qui est nécessaire est en général assez courte et, selon les proportions d'oxyde compris dans le substrat, elle se situe habituellement entre environ une minute et une quinzaine de minutes. Pour une durée de traitement donnée, il est possible d'agir encore sur la vitesse de réduction en ajoutant dans le milieu des accélérateurs variés comme par exemple de l'acide borique, de l'acide oxalique, de l'acide citrique, de l'acide tartrique ou des chlorures de métaux tels que le chlorure de cobalt-II, de nickel-II, de fer-II, de manganèse-II, de cuivre-II.

La réduction qui est opérée dans l'intervalle de temps indiqué ci-avant concerne une partie seulement de l'épaisseur du film. A noter que pour des applications électriques, on veille à ne rèduire qu'une partie seulement de l'épaisseur du film afin de conserver une partie interne non réduite, isolante pour éviter tout phénomène parasite de pontage conducteur. Par contre s'il a été prévu des trous, on constate qu'une couche, au minimum de même épaisseur qu'en surface est aussi réduite sur le pourtour des trous.

Etant donné l'état très divisé du cuivre obtenu après le traitement réducteur, on devait s'attendre à ce que son oxydation à l'air soit rapide. Or on a constaté qu'il n'en est rien et que le niveau de la résistivité superficielle du film après réduction n'évolue pas pendant plusieurs jours de conservation à l'air ambiant.

Il est donc possible de stocker dans cet état le film réduit. On peut prévoir à titre de précaution soit un rinçage incomplet laissant des traces de réducteur à la surface du film, soit l'addition au bain de rincage d'un agent réducteur particulier par exemple d'hydroquinone soit la protection du film rincé et séché par enduction d'un film protecteur par exemple de photorésist.

Le film réduit peut ensuite être métallisé par dépôt d'une couche de cuivre, de nickel ou d'un autre métal. Cette métallisation peut être faite par voie chimique sans courant, mais il a été constaté et ceci constitue un des avantages essentiels liés à la mise en oeuvre de la présente invention, qu'elle peut être faite aussi directement par voie électrolytique. Dans certaines applications, il n'est pas rare de rechercher un dépôt de couche métallique d'au moins 20 microns, aussi la possibilité de pouvoir utiliser directement la voie électrolytique correspond-elle vraiment à un procédé industriellement rentable. Il est possible bien entendu de procéder, de manière classique, d'abord à une métallisation par voie chimique sans courant, puis de renforcer ce premier dépôt

par un dépôt ultérieur électrolytique. Pour avoir une description détaillée des conditions opératoires propres à la métallisation électrochimique, on peut se reporter à l'ouvrage "Encyclopedia of Polymer Science and Technology, 1968, volume 8, pages 658 à 661". Les proportions des constituants du bain électrochimique, la durée de l'immersion du film, la température et les autres conditions opératoires sont déterminées dans chaque cas particulier de manière connue en soi pour obtenir les meilleurs résultats.

La métallisation par électrolyse est bien connue; cf. notamment "Encyclopedia of Polymer Science and Technology, 1968, volume 8, pages 661 à 663". Le film convenablement réduit constitue la cathode et le métal à déposer l'anode. Tous deux sont immergés dans un électrolyte traversé par un courant. Par exemple dans le cas d'un cuivrage électrolytique, le métal déposé peut procéder du cuivre monovalent ou bivalent et provenir d'un électrolyte cyanuré (cuivre monovalent) ou d'un électrolyte à base de sulfate, pyrophosphate ou fluoborate (cuivre bivalent). Plusieurs adjuvants peuvent être ajoutés dans l'électrolyte: un sel alcalin ou alcalino-terreux, un acide (bain de cuivrage acide au sulfate de cuivre) ou une base (bain d'étamage alcalin au stannate) pour augmenter la conductivité de l'électrolyte; un agent tampon pour éviter les variations rapides du pH; des corps modifiant la structure des électrodépôts comme par exemple des colloïdes, des agents tensio-actifs, un phénol, un phénol sulfoné, un brillanteur minéral ou organique, un agent nivelant tel que par exemple la coumarine. La qualité de l'électrodépôt, qu'il soit d'un métal ou d'un alliage métallique, va dépendre de la composition de l'électrolyte et des conditions physiques de l'électrolyse (température, densité de courant cathodique et anodique, distance anode-cathode, conditionnement superficielles des électrodes, etc.); le réglage de ces différents paramètres sera fait dans chaque cas particulier de manière connue en soi.

Le fait de pouvoir propager la réduction dans l'épaisseur du film va permettre d'engendrer les avantages suivants: lors de la métallisation, il y aura un ancrage profond du métal déposé dans le substrat résineux; dans le cas d'une soudure avec un apport de métal formant un alliage, l'alliage pourra migrer également à l'intérieur du substrat puisqu'il y a une réelle continuité du cuivre dans l'épaisseur du substrat; dans le cas d'une métallisation destinée à jouer le rôle de drain thermique, il sera possible d'agir sur le transfert thermique de la résine en faisant progresser plus ou moins la réduction dans la masse du film.

Selon la durée du traitement électrolytique on pourra obtenir des couches métalliques dont l'épaisseur est supérieure ou égale à 1 micron, couches enracinées dans le film et présentant une bonne cohésion, contrairement à ce qui se passe avec des dépôts "Electroless". Des films comportant une couche de cuivre aussi mince que 1 micron d'épaisseur présentent un grand intérêt pour la réalisation de circuits imprimés, car ils permettent lors des traitements ultérieurs de gravure de supprimer les défauts et notamment la sous-gravure. On peut ainsi augmenter la densité de la circuiterie et augmenter la fiabilité des circuits.

Il va de soi que l'on peut obtenir aussi des dépots métalliques beaucoup plus importants, de l'ordre de 20 à 50 microns par exemple, dépôts correspondant aux techniques actuellement utilisées pour la réalisation de circuits imprimés. On peut de même déposer par fusion ou par voie électrolytique des couches d'alliage de type plomb/étain.

La réalisation de circuits imprimés à partir de films réduits peut alors se faire selon les procédés additifs classiques et la réalisation de circuits à partir de films réduits et métallisés par voie électrolytique, par gravure classique.

Schématiquement, pour l'obtention de circuits à trous traversants on peut indiquer brièvement deux méthodes possibles. La première méthode "Pattern plating" consiste en partant du film préparé selon l'invention à percer des trous aux emplacements prévus et selon le mode de perçage à dépoussièrer puis à appliquer le photorésist, à le développer puis à réduire l'oxyde cuivreux selon l'invention. Après un rincage à l'eau on opère une métallisation chimique (méthode Electroless), on rince puis on élimine le photorésist, on rince et on sèche.

Des variantes peuvent être apportées à cette méthode qui sera de toute façon lente à cause de la phase de métallisation chimique.

La deuxième méthode industriellement beaucoup plus intéressante ou "Panel plating" consiste en partant du film préparé selon l'invention à percer des trous aux emplacements prévus, éventuellement à dépoussierer puis à réduire l'oxyde cuivreux selon l'invention, à rincer à l'eau, à appliquer le photorésist, à le développer puis à métalliser par voie électrolytique. Après rincage on élimine le photorésist puis on effectue la gravure non sélective. On rince puis on sèche.

Cette méthode qui comporte une phase de plus que la méthode précédente est en réalité beaucoup plus rapide puisque la métallisation par voie électrolytique peut être 100 fois plus rapide que par voie chimique. De plus de très nombreuses variantes peuvent être apportées qui permettent d'améliorer et la rapidité du procédé et la qualité du produit fini obtenu.

Le procédé selon l'invention permet aussi d'obtenir des films métallisés comportant une couche de cuivre ancrée dans le polymère pouvant être aussi faible que 1 micron tout en étant cohérente et résistante. Il sera distingué des procédés antérieurs <u>par sa simplicité:</u> pas de sensibilisation et d'activation du film, possibilité d'éviter la phase délicate de décapage superficiel de l'oxyde cuivreux inclus dans le substrat; <u>par son faible coût:</u> pas d'emploi de sels de palladium chers ou de métaux

pulvérulents nobles. De plus sa technologie est adaptée aux équipements existants. Il permet en outre d'obtenir par des méthodes simplifiées la réalisation de circuits imprimés, éventuellement à trous traversants dans des conditions économiques jamais trouvées jusqu'à présent.

Les possibilités de variantes sont très nombreuses, car à chaque étape du procédé il est possible de l'interrompre par exemple par un stockage du produit semi-fini pour le reprendre ultérieurement.

Les exemples suivants donnés à titre non limitatif illustrent l'invention et montrent comment elle peut être mise en oeuvre.

**Exemple 1**

Préparation d'un collodion de polytrimellimide - amide à 18 % environ d'extrait sec destiné à la fabrication de films chargés à l'oxyde cuivreux. Le solvant utilisé est la N-méthylpyrrolidone.

Dans un réacteur de 110 litres équipé avec:

- un motoréducteur de 1CV entrainant un agitateur cadre tournant à 50 tours/mn.
- une double enveloppe dans laquelle circule un liquide caloporteur chauffé par une bougie électrique de 8 KW et dont la température est régulée, le refroidissement étant assuré par un circuit secondaire
- une prise de température dans la masse avec enregistreur de 0 à 200°C.
- un condenseur en verre de diamètre 75 mm, hauteur 750 mm prolongé par une tuyauterie de dégazage au toit par l'intermédiaire d'un ballon barboteur contenant de la N-méthylpyrrolidone (NMP). Un compteur est installé en aval du barboteur pour contrôle du dégagement gazeux.
- une vanne de fond "quart de tour", de 50 mm de passage.
- une arrivée d'azote pour balayage en surface à partir d'une bouteille.
- une aspiration mobile pouvant être placée sur le tampon de charge.
- une pompe (1-10 l/heure) pour introduction de la NMP de dilution stockée dans un récipient respirant sur baudruche d'azote.

On charge sous léger courant d'azote, dans l'ordre et sous agitation 41,44 kg de N-méthylpyrrolidone, redistillée (teneur en eau 200 ppm); 10,08 kg de diisocyanato- 4,4' diphényléther (point de fusion 62-64°C, chlore hydrolysable inférieur à 50 ppm) et 7,68 kg d'anhydride trimellique.

On tamponne le réacteur et balaye le volume libre pendant 30 mn par un courant d'azote (1000 l/heure) et commence aussitôt à chauffer selon le programme suivant:

| Durée | T° bain °C | T° masse °C |
|---|---|---|
| 0 | 20-30 | 20-30 |
| 1h 30 mm | 105-115 | 115-120 |
| 1h 50 mm | 135-140 | 135-140 |
| 2h 30 mm | 145-155 | 145-150 |
| 3h | 170-180 | 180 |
| 5h | 185-190 | 180-185 |

Le dégagement du gaz carbonique commence vers 80°C, atteint son maximum à 110-120°C (1800 l/heure environ) et s'arrête entre 170 et 180°C. Dès le début du palier à 180-185°C on commence l'injection de 28 kg de N-méthylpyrrolidone de dilution en 3 heures. Pendant ce temps on poursuit le chauffage afin d'atteindre 190°C dans la masse, cette température étant ensuite maintenue pendant toute la durée de la réaction.

Une première prise d'échantillon est faite après 10 heures de marche et le résultat de la mesure de viscosité (viscosimètre de Brookfield) porté sur un diagramme semi-logarithmique.

La viscosité du collodion se situe, à ce moment là, entre 50 et 200 poises à 25°C.

Suivant les résultats donnés par cette première prise, les suivantes sont effectuées toutes les 2 heures et l'on trace la courbe de montée en viscosité.

On met en refroidissement lorsque la viscosité du collodion atteint 1000 à 1100 poises afin d'obtenir un produit final de viscosité comprise entre 1000 et 1500 poises, la montée en viscosité se poursuivant au cours du refroidissement.

Le refroidissement s'effectue sous léger contre-courant d'azote et le soutirage est fait à 80°C.

On récupère 80 kg de collodion (théorie 83,70 kg) dont la viscosité à 25°C est de 1300 poises (viscosimètre de Brookfield) et l'extrait sec de 18 % (étuve ventillée 3 heures à 220°C sur un échantillon de 2 g environ en couche mince).

(2) Préparation du collodion chargé à l'oxyde cuivreux

Dans un réacteur de 1,5 l équipé d'un agitateur en acier inoxydable de type ancre dont les pales vrillées en forme hélicoïdale passent à 2 mm de la paroi du réacteur, on introduit 400 g du collodion précédemment préparé et 200 g de N-méthylpyrrolidone, et on agite pendant 15 heures à 20-25°C afin d'homogénéiser. La teneur en extrait sec du collodion est ainsi ramenée à 12% et sa viscosité à 160 poises (viscosimètre de Brookfield).

Parallèlement, dans un erlen de 50 ml, on met à dissoudre 0,720 g d'anhydride trimellique soit 1% par rapport à la matière sèche contenue dans le collodion; 0,720 g de diamino-4,4' diphényléther soit également 1% par rapport à la matière sèche contenue dans le collodion; 1,44 g de NUOPERSE 657$^R$ (dispersant favorisant la répartition des pigments commercialisé par la société NUODEX-FRANCE) soit 2 % par rapport à la matière sèche contenue dans le collodion, dans 18 g de N-méthylpyrrolidone, 6 g d'acétylacétone et 3 ml

d'une solution contenant 750 mg d'huile polysiloxanique méthyl phényl hydroxylée commercialisée sous la référence 640 V100 de Rhone-Poulenc, dans 50 ml de N-méthylpyrrolidone soit 45 mg d'huile 640 V100 (0,0625 % par rapport à la matière sèche contenue dans le collodion).

Cette solution est ajoutée au collodion de polytrimellimide-amide dont l'extrait sec a été ramené à 12% et la viscosité à 160 poises par addition de N-méthylpyrrolidone et on agite pendant 5 à 10 mn afin d'homogénéiser. On introduit alors sous agitation et à température ambiante en 15 mn environ, 88 g d'oxyde cuivreux soit un rapport oxyde cuivreux/matière sèche contenue dans le collodion = 55/45 et l'homogénéisation est poursuivie pendant une heure. Le collodion chargé est alors traité sur machine monobarre commercialisée par la Société Spagenberg afin de disloquer les éventuels agglomérats d'oxyde cuivreux, stocké dans un poudrier de 1,5 l et débullé en dessicateur sous 20 mm de mercure, à température ambiante pendant 1 à 2 heures.

(3) Confection de films à partir du collodion chargé à l'oxyde cuivreux

Sur des plaques de verre de 500 x 430 x 8 mm, on dépose à l'aide d'une couleuse à trémie de 35 cm calée à 6/10 mm des films du collodion chargé, préparé au paragraphe précédent. Les plaques sont alors soumises à un traitement thermique en étuve ventillé à 120° C pendant 25 minutes. A ce stade le film contient encore 20 à 25% de N-méthylpyrrolidone.

Cette opération terminée, les films peuvent être traités pendant 2 heures à 170° C en étuve ventilée afin d'éliminer totalement le solvant puis facilement décollés de leur support après retour à température ambiante. Après arrasement des bords, on obtient des formats de 450 x 320 mm dont l'épaisseur est de 90 microns sans défaut de surface. Ces films ne sont pas directement réductibles par la solution de borohydrure de potassium, une mise à jour de la charge d'oxyde cuivreux par un décapage mécanique des deux faces est nécessaire afin de pouvoir assurer la réduction du cuivre(I) à l'état de cuivre metallique (Cu°).

Une autre technique, permettant la réduction de l'oxyde cuivreux à l'état de cuivre métallique sans décapage préalable de la surface consiste en un étirage du film après le traitement thermique en étuve ventilée pendant 25 minutes à 120° C. A ce stade le film contient encore 20 à 25 % de solvant, il est décollé de son support et pincé entre les deux mors d'une machine, ces mors se déplacant parallèlement à l'aide d'une vis-mère dont les deux pas sont inversés. La machine et le film sont alors placés dans une étuve ventilée à 170° C. On procède à un premier étirage de 15 % dans le sens de la coulée en agissant sur la vis mère. Le film est alors démonté, tourné de 90 degrés par rapport aux mors et on procède à un second étirage dans le sens perpendiculaire à la coulée en opérant comme précédemment. On procède alors à un traitement thermique, en étuve ventilée à 170° C pendant deux heures afin de chasser totalement le solvant. Après arrasements des bords, on obtient des formats de 380 x 270 mm dont l'épaisseur est de 85 microns, ces films sont souples, non cassants et sans défauts de surface; ils sont réductibles par la solution de borohydrure de potassium sans décapage préalable de leur surface.

(4) Réduction des deux faces des films par la solution de borohydrure de potassium

Pour pouvoir appliquer la technique de gravure par méthode additive les films doivent être conducteurs en surface. Pour ce faire, il faut procéder à la réduction de la charge d'oxyde cuivreux à l'état de cuivre métallique par une solution de borohydrure de potassium.

Dans un erlen de 1000 l, on introduit dans l'ordre, sous agitation et après dilution de chaque réactif:

- 500 ml d'eau distillée,
- 2,5 g de soude en pastilles,
- 5 g de sel de sodium d'une carboxyméthylcellulose (type 7MF, médium viscosity, PM 250 000 d'Hercules),
- 25 g de borohydrure de potassium,
- 5 $cm^3$ d'une solution aqueuse à 1 % de Cémulsol[R] DB 311, agent de surface fabriqué et commercialisé par la Société Française d'Organo Synthèse (S.F.O.S).

La solution est prête à l'emploi.

Les films, dont la surface a été décapée mécaniquement, ou étirés sont alors enduits au trempé ou par tout autre moyen d'enduction (pinceau, pulvérisation....) par la solution réductrice préparée auparavant puis suspendus verticalement; après une durée de contact de 3 mn à 3 mn 30 s la solution réductrice et les sous-produits de la réaction sont éliminés par un lavage abondant à l'eau distillée accompagné d'un léger brossage puis à l'alcool. Les films sont alors séchés à l'air comprimé. La résistante mesurée entre deux points de la surface distants de 20 cm est de 20 à 50 ohms et après arrasement des 4 bords, il n'y a pas de continuité entre les 2 faces du film.

(5) Réalisation de circuits souples

Après réduction de l'une des faces dont la surface est de 4 $dm^2$ par la solution de borohydrure de potassium, le film est soumis à un flash électrolytique, la solution aqueuse d'électrolyte contient 20 g/litre de sulfate de cuivre ($SO_4Cu$, $5H_20$); 0,5 ml/litre d'acide sulfurique concentré et 5 ml d'additif RP 500 de Rhone-Poulenc additif pour bains de cuivrage au sulfate acide, agent nivelant et de brillantage fabriqué par la société Rhone-Poulenc désignée par RP dans ce qui suit jouant le rôle de brillanteur, la cathode étant le film lui-même et l'anode étant constituée par le métal à déposer

(cuivre). L'électrolyse est conduite pendant 7 minutes sous 0,125 A/$dm^2$ puis 7 minutes sous 0,2 A/$dm^2$, le film est rincé par un courant d'eau distillée pendant 5 minutes, lavé à l'éthanol et enfin séché à l'air comprimé. Le dépôt de cuivre ainsi obtenu est brillant et son épaisseur est d'environ 4 microns.

On dépose alors au pinceau ou par toute autre méthode d'enduction une couche de photorésist positif à base de résine formophénolique et d'un sensibilisateur dérivé du sulfo-5 naphtoquinone diazide-1,2, commercialisé sous la marque Maskoat$^R$ 11 par RP et on abandonne pendant 15 minutes à température ambiante sous une hotte à flux laminaire dans un plan parfaitement horizontal. Le séchage est réalisé dans un four à tapis horizontal pendant 30 minutes avec trois plages de températures 80-90 et 100° C.

Le film du photorésist est surmonté d'un tracé négatif du circuit à reproduire, est alors insolé pendant 40 secondes sous le rayonnement d'une lampe à émission de rayons ultra-violets d'une puissance de 2000 W.

Le photorésist est alors développé sous agitation pendant 3 minutes dans une solution à 30 % en volume de développeur (solution aqueuse alcaline de phosphates et de silicates) commercialisé sous la marque Maskoat$^R$ 13 par RP, suivi d'un rinçage sous courant d'eau distillée pendant 5 minutes et d'un séchage à l'air comprimé.

On procède alors à un renfort électrolytique du circuit dont la surface est de 40 $cm^2$ avec un bain électrolytique dont la composition est la suivante:

| | | |
|---|---|---|
| Sulfate de cuivre ($SO_4Cu$, 5 $H_2O$) | 75 | g/litre |
| Acide sulfurique concentré | 180 | mg/litre |
| Chlorure de sodium | 50 | mg/litre |
| Additif RP 500 de RP | 5 | ml/litre |

L'électrolyse est conduite pendant 1 heure sous une densité de courant de 3A/$dm^2$ et de le circuit est rincé par un courant d'eau distillée pendant 5 minutes puis séché à l'air comprimé.

Le photorésist est ensuite éliminé par lavage à l'acétone et le flash électrolytique détruit par immersion dans une solution aqueuse de chlorure ferrique à 10 % pendant 3 minutes, on rince à l'eau distillée, traite par une solution aqueuse à 1 % d'acide sulfurique pendant 1 à 2 secondes, lave à l'eau distillée puis à l'éthanol, et séche à l'air comprimé. On obtient un circuit dont l'épaisseur des pistes cuivrées est de 35 microns, la surface est brillante et la définition excellente.

**Exemple 2**

A une solution de 200 g de diamino-4,4' diphényléther (1 mole) dans 2300 g de N,N-diméthylacétamide (DMAC) on ajoute lentement, sous agitation 207 g (0,95 moles) de dianhydride pyromellitique. La vitesse d'ajout du dianhydride est réglée par l'élévation de température du contenu du réacteur, qui ne doit pas dépasser 50° C.

On augmenteé la viscosité du collodion de faible viscosité ainsi obtenu par ajout d'une solution de dianhydride dans le DMAC, 11 g dans 110 g, soit le complément pour atteindre la composition stoéchiométrique.

La viscosité du collodion croît rapidement, par allongement des chaînes pour atteindre environ 1600 poises à température ambiante en fin d'addition pour un collodion à 17,3 % de matière solide: polyamide-acide.

A ce collodion est ajouté sous agitation 0,2 g d'huile polysiloxanique méthyl phényl hydroxylée (huile 640 V100 de RP) et enfin 420 g d'oxyde cuivreux préalablement séché puis empâté par du DMAC. Après homogénéisation le collodion chargé est traité comme une peinture, par passage sur machine monobarre pour parfaire la dispersion du pigment et supprimer les agglomérats de charges dont la dimension moyenne des particules unitaires est de 1 micron.

Pour achever le débullage du collodion chargé, il est soumis à un vide de 50 mm de mercure, à température ambiante, dans le bouilleur d'un évaporateur rotatif.

Ce collodion est ensuite coulé sur glace à l'aide d'un racle avec passage de 350 microns et séché en étuve ventilée pendant 30 minutes à 125° C.

Le film décollé de son support est fixé sur une plaque de verre, par des pinces à dessin, les bords du film étant rabattus sur les bords du support.

Cet ensemble est alors introduit en étuve sous vide et la température portée à 300° C et maintenue pendant 60 minutes pour assurer la conversion en polyimide.

Le film obtenu est très souple, résistant à la traction et au pliage malgré sa forte charge. Les deux faces sont légèrement différentes, la face inférieure (côté support) est plus brillante que la face superieure. La résistivité électrique est de 3,1 x $10^{16}$ ohms cm.

Le film est décapé légèrement sur l'une de ses faces par frottements à l'aide d'une suspension d'alumine dans l'eau. Après élimination des résidus de décapage par léger brossage sous courant d'eau, le film est rincé à l'alcool et séché.

La face décapée est alors réduite par dépôt d'une composition réductrice.

La composition réductrice à base de borohydrure de potassium est préparée de la façon suivante:

- 100 ml d'eau distillée,
- 0,5 g de soude en pastille,
- 5 g de sel de sodium de carboxyméthylcellulose (type 7MF d'Hercules),
- 5 g de borohydrure de potassium,
- 1 $cm^3$ de Cémulsol$^R$ DB 311 dilue 100 fois dans l'eau.

Après 5 minutes de contact la composition réductrice qui a pris des reflets argentés très

prononcés est éliminée par rinçage sous courant d'eau, puis rinçage à l'alcool et séchage.

La surface traitée, conductrice de l'électricité est alors soumise à un dépôt électrolytique léger de cuivre. Le bain d'électrolyse au sulfate de cuivre est très légèrement acidifié par $H_2SO_4$ (0,3 ml/litre d'acide de densité 1,83) et contenant 5 ml/litre de brillanteur RP 500 de Rhone-Poulenc.

Le dépôt de cuivre est conduit sous 0,15 A/$dm^2$ pendant quelques minutes pour obtenir une épaisseur d'environ 2 microns.

Le film est alors décapé comme précédemment sur sa face non traitée à l'aide d'abrasif en suspension puis perforé avec un emporte pièce de diamètre 2 mm.

L'opération de réduction effectuée précédemment est réalisée sur la face décapée avec la même composition, par deux fois, avec rinçage et séchage intermédiaire.

Cette face réduite, après rinçage et séchage, est réduite au pinceau par un photorésist positif Maskoat[R] 11 de RP puis séchée et enfin isolée au travers d'un masque cachant chaque perforation sous un carré de 5 mm de côté.

Après développement dans une solution aqueuse de développeur Maskoat[R] 13 de RP puis rinçage et séchage, on procède au renforcement électrolytique du film sur ses deux faces et sur les parois des trous avec un bain d'électrolyse précédemment utilisé.

Après quelques minutes de renforcement, l'opération est poursuivie dans un bain plus concentré (75 g/litre de $SO_4$ Cu, 5 $H_2O$ + 180 g/litre de $H_2SO_4$ de densité 1,83 + 50 mg/litre de NaCl + 5 ml de RP 500) et sous une densité de courant de 3 A $dm^2$ pendant 45 minutes.

Le film est alors rincé à l'eau, puis à l'acétone pour éliminer le photorésist, puis une solution aqueuse de $FeCl_3$ pour éliminer le cuivre réduit non renforcé et enfin à l'eau et à l'alcool.

Les jonctions électriques recto-verso assurées par les trous métallisés sont satisfaisantes.

## Revendications

1. Procédé de métallisation de films souples, électriquement isolants en polymère thermodurcissable à groupements imides ou amides aromatiques, caractérisé en ce qu'il comprend la succession d'étapes suivantes:

(1) on prépare un collodion filmogène du polymère thermodurcissable ou d'un prépolymère de celui-ci, contenant de 20 à 60 % en poids d'un oxyde cuiveux sous forme de particules,

(2) on forme un film à partir du collodion obtenu,

(3) on met à jour, si besoin est, sur au moins une portion de la surface du film, les grains d'oxyde cuivreux,

(4) on réduit l'oxyde cuivreux en cuivre métallique par traitement avec un borohydrure d'au moins une portion de la surface du film pour la rendre conductrice de l'électricité,

(5) on renforce ladite surface, éventuellement par voie électrolytique.

2. Procédé selon la revendication 1 caractérisé en ce que le polymère est un polyimide ou un polyimide amide ou un polyamide aromatique.

3. Procédé selon la revendication 1 caractérisé en ce que la mise à jour des grains d'oxydes cuivreux est au moins partiellement réalisée par un étirage du film.

4. Procédé selon la revendication 1 caractérisé en ce que les borohydrures utilisables sont choisis parmi les borohydrures alcalins non substitués et les borohydrures substitués dans lesquels au plus trois atomes d'hydrogène de l'ion borohydrure ont été remplacés par des substituants inertes dans les conditions de réduction.

5. Procédé selon la revendication 1 caractérisé en ce que l'agent réducteur est mis en contact avec le film sous forme d'une solution dans l'eau ou dans un mélange d'eau et d'un solvant polaire inerte sont la concentration, exprimée en pourcentage en poids d'hydrogène actif du borohydrure dans la solution, est comprise entre 0,05 et 1 %.

6. Films souples susceptibles d'être obtenus selon le procédé de la revendication 1 et dont la couche de cuivre cohérente, après renforcement électrolytique, a une épaisseur supérieure ou égale à 1 micromètre.

7. Films souples susceptibles d'être obtenus après l'étape (4) du procédé, selon la revendication 1 et dont la couche réduite présente, avant renforcement électrolytique une résistivité superficielle comprise entre 0,01 Ω/□ et $10^3$ Ω//□.

8. Procédé de fabrication de circuits imprimés caractérisé en ce que le film conformé et étiré selon la revendication 3 est soumis aux opérations suivantes:

a) enduction par un photorésist du film réduit éventuellement renforcé électrolytiquement,

b) développement du photorésist,

c) renforcement électrolytique direct,

d) élimination du photorésist,

e) gravure non sélective.

9. Procédé selon la revendication 8 caractérisé en ce qu'un dépôt électrolytique d'étain-plomb est réalisé après le renforcement électrolytique et avant l'élimination du photorésist.

10. Procédé de fabrication de circuits imprimés à trous traversants, caractérisé en ce que le film conformé et étiré selon la revendication 3 est perforé puis réduit puis renforcé électrolytiquement puis enduit par un photorésist qui est developpé, puis renforcé électrolytiquement avant élimination du photorésist et gravure non sélective.

**Patentansprüche**

1. Verfahren zum Metallisieren von flexiblen, elektrisch isolierenden Filmen aus einem wärmehärtbaren Polymeren mit aromatischen Imid- oder Amidgruppen,
dadurch gekennzeichnet, daß es folgende Stufen umfaßt:
(1) man stellt ein filmbildendes Collodium des wärmehärtbaren Polymeren oder des Prepolymeren her, enthaltend 20 bis 60 Gew.-% Kupfer(II)-oxid in Form von Teilchen,
(2) man formt einen Film ausgehend von dem erhaltenen Collodium,
(3) man legt, wenn erforderlich, auf mindestens einem Teil der Filmoberfläche die Kupfer(II)-oxidteilchen frei,
(4) man reduziert das Kupfer(II)-oxid zu metallischem Kupfer durch Behandlung mindestens eines Teils der Filmoberfläche mit einem Borhydrid, um sie elektrisch leitend zu machen,
(5) man verstärkt diese Fläche, gegebenenfalls auf elektrolytischem Wege.

2. Verfahren nach Anspruch 1,
dadurch gekennzeichnet, daß das Polymer ein aromatisches Polyimid oder Polyimid-amid oder Polyamid ist.

3. Verfahren nach Anspruch 1,
dadurch gekennzeichnet, daß das Freilegen der Kupfer(II)-oxidteilchen zumindest teilweise durch Recken des Films bewirkt wird.

4. Verfahren nach Anspruch 1,
dadurch gekennzeichnet, daß die brauchbaren Borhydride ausgewählt werden aus den nicht substituierten Alkaliborhydriden und den substituierten Borhydriden, bei denen höchstens drei Wasserstoffatome des Borhydridions durch Substituenten ersetzt worden sind, die unter den Reduktionsbedingungen inert sind.

5. Verfahren nach Anspruch 1,
dadurch gekennzeichnet, daß der Film mit dem Reduktionsmittel in Form einer Lösung in Wasser oder in einem Gemisch aus Wasser und einem polaren inerten Lösungsmittel in Berührung gebracht wird, deren Konzentration, angegeben in Gew.-% aktiver Wasserstoff des Borhydrids in der Lösung, 0,05 bis 1 % beträgt.

6. Flexible Filme, die gemäß dem Verfahren des Anspruchs 1 erhalten werden können und deren kohärente Kupferschicht nach der elektrolytischen Verstärkung eine Stärke von 1 µm oder mehr aufweist.

7. Flexible Filme, die nach Anspruch 1, Stufe (4) des Verfahrens, erhalten werden können und deren reduzierte Schicht, vor der elektrolytischen Verstärkung, einen spezifischen Oberflächenwiderstand von 0,01 Ω/□ bis $10^3$ Ω/□ aufweisen.

8. Verfahren zur Herstellung von gedruckten Schaltungen, dadurch gekennzeichnet, daß der geformte und gereckte Film nach Anspruch 3 folgenden Arbeitsgängen unterworfen wird:
(a) Beschichten des reduzierten und gegebenenfalls elektrolytisch verstärkten Films mit einem Photoresist,
(b) Entwicklung des Photoresists,
(c) direkte elektrolytische Verstärkung,
(d) Entfernen des Photoresists,
(e) nicht-selektive Gravur.

9. Verfahren nach Anspruch 8,
dadurch gekennzeichnet, daß man nach der elektrolytischen Verstärkung und vor dem Entfernen des Photoresists auf elektrolytischem Wege einen Auftrag aus Zinn-Blei aufbringt.

10. Verfahren zur Herstellung von gedruckten Schaltungen mit durchgehenden Öffnungen,
dadurch gekennzeichnet, daß der geformte und gereckte Film nach Anspruch 3 perforiert, dann reduziert, dann elektrolytisch verstärkt, dann mit einem Photoresist überzogen und dieser entwickelt und dann elektrolytisch verstärkt wird vor dem Entfernen des Photoresists und der nicht selektiven Gravur.

**Claims**

1. Process for the metallization of electrically insulating flexible films of a thermosetting polymer containing aromatic imide or amide groupings, characterized by the following sequence of stages:
(1) a film-forming collodion of thermosetting polymer or prepolymer containing 20 to 60% by weight of a cuprous oxide in the form of particles is prepared,
(2) a film is formed from the collodion obtained,
(3) the grains of cuprous oxide are revealed, if need be, over at least a part of the film surface,
(4) the cuprous oxide is reduced to metallic copper by treatment of at least a part of the film surface with a borohydride in order to make it electrically conductive,
(5) the said surface is reinforced, electrolytically if appropriate.

2. Process according to Claim 1, characterized in that the polymer is an aromatic polyimide, polyimideamide or polyamide.

3. Process according to Claim 1, characterized in that the revealing of the grains of cuprous oxide is at least partially produced by drawing the film.

4. Process according to Claim 1, characterized in that the borohydrides which can be used are chosen from unsubstituted alkali metal borohydrides and substituted borohydrides in which at most three hydrogen atoms of the borohydride ion have been replaced by substituents which are inert under the conditions of reduction.

5. Process according to Claim 1, characterized in that the film is brought into contact with the reducing agent in the form of a solution in water or in a mixture of water and an inert polar solvent, the concentration of which, expressed as the percentage by weight of the active hydrogen of the borohydride in the solution, is between 0.05

and 1 %.

6. Flexible films capable of being obtained according to the process of Claim 1, and in which, after electrolytic reinforcement, the cohesive copper layer has a thickness greater than or equal to 1 micrometre.

7. Flexible films capable of being obtained after stage (4) of the process according to Claim 1 and in which, before electrolytic reinforcement, the reduced layer has a surface resistivity of between 0.01 Ω/□ and $10^3$ Ω/□.

8. Process for the manufacture of printed circuits, characterized in that the film formed and drawn according to Claim 3 is subjected to the following operations:

a) coating of the reduced film, if appropriate electrolytically reinforced, with a photoresist,

b) development of the photoresist,

c) direct electrolytic reinforcement,

d) removal of the photoresist,

e) nonselective etching.

9. Process according to Claim 8, characterized in that a tin/lead electrolytic deposit is produced after the electrolytic reinforcement and before the removal of the photoresist.

10. Process for the manufacture of printed circuits with feedthroughs, characterized in that the film formed and drawn according to Claim 3 is perforated then reduced then reinforced electrolytically then coated with a photoresist, which is developed, and then reinforced electrolytically, before removal of the photoresist and nonselective etching.